# EUROPEAN PATENT SPECIFICATION

(11) **EP 2 719 512 B1**
(45) Date of publication and mention of the grant of the patent: **07.06.2017**
(21) Application number: 12800973.5
(22) Date of filing: 08.06.2012
(51) Int. Cl.: B29C 33/42, B29C 45/26, C08L 83/16

(54) **PRODUCTION METHOD FOR A BEZEL FOR A DISPLAY PANEL USING MOULD CASTING.**
VERFAHREN ZUR HERSTELLUNG EINER BLENDE FÜR EINE ANZEIGETAFEL MIT FORMGUSS.
PROCÉDÉ DE FABRICATION D'UN CADRAN D'UN PANNEAU D'AFFICHAGE GRÂCE À UN SURMOULAGE.

(30) Priority: 13.06.2011 KR 20110056663
(43) Date of publication of application: 16.04.2014
(73) Proprietor: LG Hausys, Ltd., Seoul 150-876 (KR)
(72) Inventor: YANG, In-Suk, Ulsan 681-250 (KR); LEE, Jong-Chul, Cheongju-si Chungcheongbuk-do 361-775 (KR); LEE, Jae-Eun, Seoul 139-896 (KR)
(74) Representative: Zacco Denmark A/S
(86) International application number: PCT/KR2012/004520
(87) International publication number: WO 2012/173356

(56) References cited:
- JP-A- H04 325 211
- JP-A- 2004 050 819
- KR-A- 20090 019 226
- KR-A- 20110 012 581
- KR-A- 20120 031 575
- KR-A- 20120 081 391
- KR-B1- 100 886 748
- US-A1- 2010 182 560

## Description

### [Technical Field]

The present invention relates to a method for manufacturing a bezel which is attached to a rim of a display panel and supports the display panel, and a bezel for display panels manufactured by the same, and more particularly, to a method for manufacturing a bezel for display panels using mold casting, which facilitates formation of a three-dimensional pattern while reducing unnecessary material costs.

### [Background Art]

"Bezels" refer to frames, chassis, and the like, which are used to support and/or receive various panels such as liquid crystal display panels, plasma display panels, and the like.

Generally, a liquid crystal display device, used as a display device for televisions, monitors for personal computers, mobile phones, and the like, includes a display panel and a bezel supporting and receiving the display panel.

Typically, such a bezel for liquid crystal display panels is manufactured by extruding an acrylic resin and removing a central portion of the resultant to form a planar frame.

However, in a typical method for manufacturing a bezel for display panels in the related art, a planar frame is prepared by removing a central portion of an acrylic plate, so that large amounts of the acrylic plate are cut and discarded, thereby causing increase in manufacturing costs.

In addition, since conventional bezels for display panels are manufactured by extruding acrylic resins, it is difficult to realize a three-dimensional pattern providing a sense of depth.

In the case of forming a three dimensional surface pattern through extrusion molding, there is a problem in that extrusion molding can only provide a relatively thin three-dimensional pattern due to bezel strength.

Moreover, in the case of forming a three dimensional surface pattern through injection molding, although a relatively thick three-dimensional pattern can be formed, it is difficult to provide large screen size due to mold deformation or mold separation.

### [Disclosure]

### [Technical Problem]

It is an aspect of the present invention to provide a method for manufacturing a bezel for display panels, which can reduce material costs, prevent deformation of a three dimensional surface pattern, and facilitate mold separation.

### [Technical Solution]

In accordance with one aspect of the present invention relates to a method for manufacturing a bezel surrounding and supporting a rim of a display panel, comprising:
(a) preparing a mold (S110, S510, S610), the mold being formed on a molding surface thereof with a three-dimensional pattern for imparting a surface shape to a bezel and the molding surface of the mold is coated with a release agent;
(b) fastening a gasket (S210, S510, S620) to a rim of the molding surface of the mold;
(c) injecting a polymeric raw material (S140, S530, S630) for the bezel onto the molding surface of the mold; and
(d) curing the polymeric raw material (S150, S550, S640) while transferring the three-dimensional pattern from the molding surface of the mold to the polymeric raw material;
(e) further curing an unreacted portion of the polymeric raw material through a heat treatment (S160, S560),
(g) coating at least one surface of the bezel with a glass film (S170, S570, S650), the at least one surface of the bezel comprising a transferred three-dimensional pattern, and the bezel being formed of a cured polymeric raw material,
wherein the mold comprises a frame attached to an outer surface of the mold, and the frame is formed of a glass or metal honeycomb plate.

According to an embodiment
(a) the mold to be prepared is a lower mold (210), the lower mold being formed on a molding surface (215) thereof with a three-dimensional pattern for imparting a surface shape to a bezel;
(b) fastening a gasket (220) to a rim of the molding surface of the mold;
(c) fastening an upper mold (410) to the gasket, the upper mold being formed with a raw material injection port and then injecting the polymeric raw material for the bezel onto the molding surface of the mold through the raw material injection port of the upper mold; and
(d) curing the polymeric raw material while transferring the three-dimensional pattern from the molding surface of the lower mold to the polymeric raw material.

According to an embodiment
(a) the mold to be prepared is a lower mold being formed on a molding surface thereof with a three-dimensional pattern for imparting a surface shape to a bezel;
(b) fastening a gasket to a rim of the molding surface of the lower mold;
(c) injecting the polymeric raw material for the bezel onto the molding surface of the lower mold and then fastening an upper mold to the gasket on the lower mold; and
(d) curing the polymeric raw material while transferring the three-dimensional pattern from the molding surface of the lower mold to the polymeric raw material.

According to any embodiment, the glass film of step (g) may comprise a polysilazane.The polysilazane may comprise repeated units represented by Formula 1: 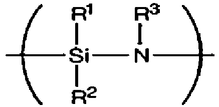 wherein R¹, R² and R³ are a hydrogen atom or a C₁-C₈ alkyl group, such as a methyl group, an ethyl group, a propyl group, and a butyl group.

According to any embodiment, the polysilazane may be perhydropolysilazane.

According to any embodiment, the polysilazane may comprise a catalytic amount of a silica conversion accelerating catalyst, and the silica conversion accelerating catalyst comprises an amine catalyst.

According to any embodiment, the three-dimensional pattern on the molding surface of the lower mold may be formed using at least one process of NC (numerical control) machining, chemical etching, and stamping.

According to any embodiment, the polymeric raw material injected in step (c) may be a thermosetting resin composition and the resin composition has a viscosity of 300 cPs to 500 cPs.

According to any embodiment, the lower mold may be formed of at least one material selected from the group consisting of metal, Teflon, and rubber materials.

According to any embodiment, the upper mold may be formed of glass or metal and may have a planar molding surface.

According to any embodiment, the upper mold may be formed on a molding surface thereof with an opposite pattern to the three-dimensional pattern formed on the molding surface of the lower mold.

In accordance with yet another aspect, a bezel for display panels includes: a substrate formed of a cured product of a resin composition, the substrate having a three-dimensional pattern on at least one surface thereof; and a glass film coated on the at least one surface of the substrate.

### [Advantageous Effects]

In a method for manufacturing a bezel for display panels according to embodiments, a bezel is manufactured by mold casting instead of extrusion, thereby reducing material costs.

In addition, in the method according to the embodiments, a three-dimensional pattern formed on a molding surface of a mold can be transferred to a cured product during curing inside a mold, thereby making it easy to impart the three-dimensional pattern to the surface of the bezel.

Further, in the method according to the embodiments, deformation of a mold can be prevented by attaching a frame formed of a material such as glass and the like, to an outer surface of a mold.

### [Description of Drawings]

Fig. 1 is a schematic flowchart of a method for manufacturing a bezel for display panels according to one embodiment of the present invention;
Fig. 2 is a sectional view of one example of a lower mold applicable to the present invention;
Fig. 3 is a plan view of one example of a lower mold applicable to the present invention;
Fig. 4 is a sectional view of another example of a lower mold applicable to the present invention;
Fig. 5 is a sectional view of one example of upper molds and lower molds applicable to the present invention;
Fig. 6 is a sectional view of another example of upper molds and lower molds applicable to the present invention;
Fig. 7 is a schematic diagram of a resin composition injected into an upper mold and a lower mold according to one embodiment of the present invention;
Fig. 8 is a schematic flowchart of a method for manufacturing a bezel for display panels according to another embodiment of the present invention;
Fig. 9 is a schematic flowchart of a method for manufacturing a bezel for display panels according to a further embodiment of the present invention.

The above and other aspects, features, and advantages of the present invention will become apparent from the detailed description of the following embodiments in conjunction with the accompanying drawings. It should be understood that the embodiments are provided for complete disclosure and thorough understanding of the invention by those skilled in the art. The scope of the present invention is defined only by the claims. Like components will be denoted by like reference numerals throughout the specification.

Now, exemplary embodiments of the invention will be described in detail with reference to the accompanying drawings.

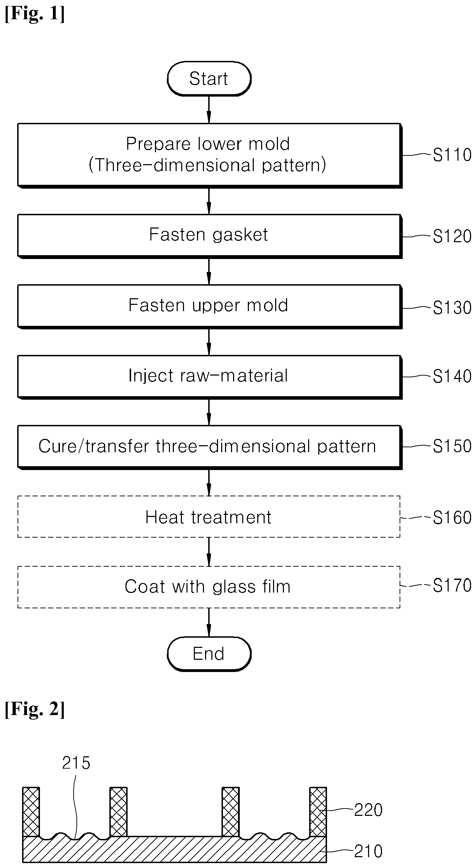

Fig. 1 is a schematic flowchart of a method for manufacturing a bezel for display panels according to one embodiment of the present invention.

Referring to Fig. 1, a method for manufacturing a bezel for display panels includes: preparing a lower mold (S110); fastening a gasket (S120); fastening an upper mold (S130); injecting a raw-material (S140); and curing/transferring a three-dimensional pattern (S150). The method include heat treatment (S160), and may further include coating a glass film (S170).

In operation (S110) of preparing a lower mold, a lower mold formed on a molding surface thereof with a three-dimensional pattern for imparting a surface shape to a bezel is prepared.

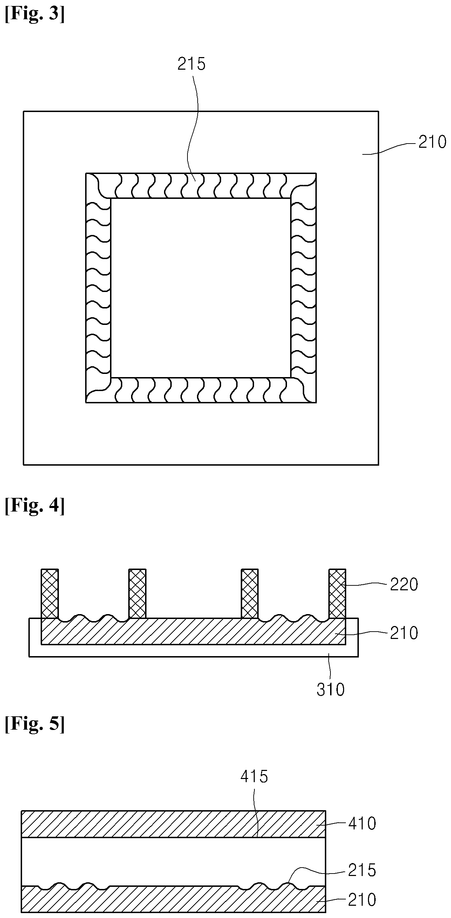

Figs. 2 and 3 are a sectional view and a plan view of one example of a lower mold applicable to the present invention, respectively.

Preferably, the lower mold 210 is formed of a material such as a metal, Teflon, rubber, and the like, which allow easy formation of the three-dimensional pattern thereon. More preferably, the lower mold 20 is formed of stainless steel exhibiting excellent corrosion resistance and strength.

As shown in Fig. 3, the three-dimensional pattern formed on the molding surface 215 of the lower mold 210 may be formed depending on a shape of the bezel for display panels.

However, these materials are vulnerable to bending and can cause deformation of the mold when used alone.

To prevent such a problem, a frame 310 formed of a material such as a glass plate, a metal honeycomb plate and the like may be attached to an outer surface of the mold, as shown in Fig. 4. The frame 310 formed of the glass plate is resistant to bending, and thus can prevent deformation of the lower mold 210.

The three-dimensional pattern formed on the molding surface 215 of the lower mold 210 may be formed by various methods, such as NC (numerical control) machining, chemical etching, stamping, and the like.

The thickness of the three-dimensional pattern to be formed on the surface of the bezel is determined depending on the three-dimensional pattern on the molding surface 215 of the lower mold 210. Therefore, when the three-dimensional pattern is formed to a thickness of 1 mm or more on the molding surface 215 of the lower mold 210, the three-dimensional pattern may also be formed to a thickness of 1 mm or more on the surface of the bezel.

The molding surface 215 of the lower mold 210 may be coated with a release agent to a thickness of about 2 µm to facilitate mold separation.

Next, in operation S210 of fastening a gasket, the gasket is fastened to a rim of the molding surface of the lower mold.

The gasket 220 forms a seal between the upper mold and lower mold, and the thickness of a molded article is determined depending on the thickness of the gasket 220. In addition, the gasket 220 may be prepared from a material, such as silicones rubbers, and the like.

Next, in operation (S130) of fastening an upper mold, the upper mold having a raw-material injection port is fastened to the gasket on the lower mold.

The upper mold may have a planar shape or a three-dimensional pattern on a molding surface thereof

As shown in Fig. 5, the upper mold 410 may have a planar molding surface. In this case, since the molding surface is required to have a smooth surface, the upper mold may be made of glass or metal, particularly, glass. Since the molding surface of the upper mold 410 has a planar shape, the bezel for display panels has a three-dimensional pattern on at least one surface thereof. Since the other surface of the bezel has a planar shape, it is easy to perform subsequent processes such as coating for surface treatment, printing for design effects, and the like on the other surface of the bezel.

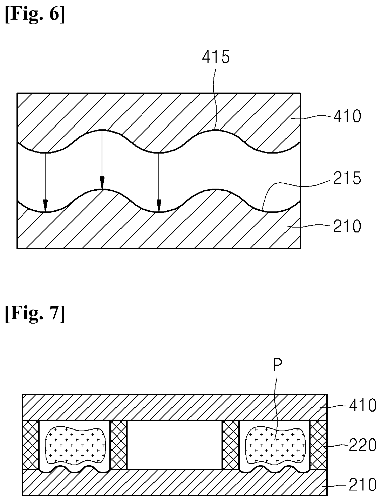

As shown in Fig. 6, the upper mold 410 may be provided with an opposite pattern to the three-dimensional pattern formed on the molding surface 215 of the lower mold 210. That is, the molding surface 415 of the upper mold 410 may have a concave portion corresponding to a convex portion on the molding surface 215 of the lower mold 210. In addition, the molding surface 415 of the upper mold 410 may have a convex portion corresponding to a concave portion on the molding surface 215 of the lower mold 210.

As shown in Fig. 6, when the upper mold 410 and the lower mold 210 have opposite three-dimensional patterns formed on the molding surfaces thereof, an injected resin composition can uniformly shrink during curing of the resin composition for the bezel. Accordingly, thickness uniformity of the three-dimensional pattern formed on the bezel for display panels may be secured, while reducing voids, which can be generated on the surface or the interior of the bezel.

Advantageously, each of the upper mold 410 and the lower mold 210 has a thickness of 3 mm to 20 mm. If the thickness of each of the upper mold 410 and the lower mold 210 is below 3 mm, the upper and lower molds can be bent. On the contrary, if the thickness of the upper mold 410 or the lower mold 210 exceeds 20 mm, it is difficult to handle the upper and lower molds.

Next, in operation (S140) of injecting a raw material, the raw material for the bezel is injected onto the molding surface of the lower mold via the raw-material injection port of the upper mold. The raw-material injection port may have a hole or slit shape penetrating the upper mold.

Injection of the raw material may be performed at room temperature, namely, about 18 °C to about 25 °C.

The raw material may be a thermosetting resin composition.

Examples of the resin composition may include acrylic resins, polycarbonate resins, ABS resin, polyurethane resins, olefin resins, epoxy resins, melamine resins, unsaturated polyester resins, and the like.

These resins may be used alone or in combination thereof. In addition, the resin composition may further include alumina trihydrate (ATH) and the like as fillers.

Depending on colors and physical properties of the bezel for display panels, the resin composition may be prepared from these resins.

For example, when manufacturing a transparent bezel for display panels, a resin composition including methyl methacrylate (MMA) and alumina trihydrate (ATH) as main components may be used as the raw material. In this case, the resin composition may have a viscosity of 300 cPs to 500 cPs. Within this range, injection molding of the resin composition can be easily performed. If the viscosity of the resin composition is less than 300cPs, curing time can increase and a molded article can have insufficient density. On the contrary, if the viscosity of the resin composition exceeds 500cPs, injection molding of the resin composition becomes difficult.

In addition, the raw material may further include pearls, pigments, chips, and the like to impart design effects to the bezel.

Next, in operation (S150) of curing/transferring a three-dimensional pattern, the raw material injected onto the molding surface of the lower mold is cured using a heat curing method. Methods for heat curing are not specifically limited. As shown in Fig. 7, the resin composition inside the molds can be cured by heating the upper mold and the lower mold into which the resin composition (P) is injected. In this case, the three-dimensional pattern is transferred from the molding surface of the lower mold to a cured product of the raw material.

Next, in operation (S160) of heat treatment, some of the raw material, unreacted in operation of curing/transferring a three-dimensional pattern, may be further cured through heat treatment.

That is, in operation of heat treatment, monomers and other components unreacted during curing are further cured, thereby completing curing the bezel for display panels.

Since this operation is performed to further cure the monomers and other components unreacted during curing, this process is performed using steam at 100°C or more, more preferably at about 100°C to 200 °C.

Duration for operation (S150) of curing/transferring a three-dimensional pattern and for operation (S160) of heat treatment may vary depending on the raw material. For example, when a resin composition including methyl methacrylate (MMA) as a main component is used as the raw material to prepare a transparent bezel for display panels, curing and heat treatment may be performed for about 3 hours and for about 2 hours, respectively. On the contrary, when a resin composition including methyl methacrylate (MMA) and alumina trihydrate (ATH) as main components is used as the raw material to prepare a white bezel for display panels, curing and heat treatment may be carried out for about 1 hour to about 2 hours and for about 30 minutes to 1 hour, respectively.

Then, the upper mold and the lower mold are separated from the bezel for display panels.

Next, in operation (S170) of coating a glass film, at least one surface of the bezel formed of a cured polymeric raw material is coated with the glass film, wherein the at least one surface has a transferred three-dimensional pattern.

The glass film performs a function of protecting the surface of the bezel and a function of retaining an outer appearance of the bezel.

The glass film may be formed of glass paints, inorganic coating solutions, or coating solutions including polysilazanes.

In the method for manufacturing a bezel for display panels according to the embodiment, the glass film may be prepared using a coating solution containing a polysilazane.

The polysilazane is a polymer having repeated Si-N (silicon-nitrogen) bonds, and any polymer allowing easy conversion into silica can be used without limitation. Generally, a Si-N (silicon-nitrogen) bond includes a silicon atom bonded with two hydrogen atoms, and is readily converted into silica.

Polysilazanes may have molecular structures such as a straight chain structure, a branched straight chain structure, a branch structure, a ring structure, a cross-linking structure, or a combination thereof. These polysilazanes may be used alone or in combination thereof. As representative examples of these polysilazanes, there are polymers including repeated silazane units represented by Formula 1. It should be noted that the polymers include an oligomer. 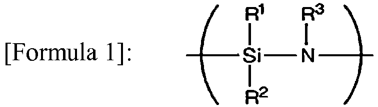 wherein R¹, R², and R³ are a hydrogen atom or a C₁-C₈ alkyl group, such as a methyl group, an ethyl group, a propyl group, and a butyl group.

To facilitate conversion into silica, the polysilazane preferably includes repeated units in which both R¹ and R² are hydrogen atoms, and more preferably, repeated units in which all of R¹, R² and R³ are hydrogen atoms.

When all of R¹, R² and R³ are hydrogen atoms, the polysilazane has repeated units represented by Formula 2, and is called perhydropolysilazane. 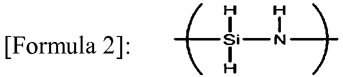 Perhydropolysilazane includes chemical structure moieties represented by Formula 3:

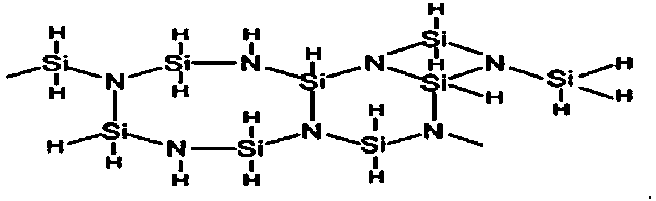

Some hydrogen atoms bonded to silicon atoms in the perhydropolysilazane may be substituted by hydroxyl groups.

After obtaining adducts through reaction between dihydrogendichlorosilane and an organic base (for example, pyridine or picoline), the perhydropolysilazane may be easily obtained by reacting the obtained adducts with ammonia.

The polysilazane, particularly, perhydropolysilazane generally has a number-average molecular weight of 100 to 50,000, preferably 200 to 2,500 in consideration of volatility and solubility.

The polysilazane, particularly, perhydropolysilazane, which is included in the glass film of the bezel according to the embodiment, may include a small amount of silica conversion accelerating catalyst.

Examples of the silica conversion accelerating catalyst may include organic amine compounds, organic acids, inorganic acids, carboxylic acid metallic salts, and organo-metallic complex salts.

Particularly, organic amine compounds are preferred, and examples of organic amine compounds may include nitrogen-containing cyclic organic amines, such as 1-methylpiperazine, 1-methylpiperizine, 4,4'-trimethylenedipiperizine, 4,4'-trimethylenebis(1-methylpiperizine), diazabicyclo-[2,2,2]octane, cis-2,6-dimethylpiperazine, 4-(4-methylperizine)pyridine, pyrizine, dipyridine, α-picoline, β-picoline, γ-picoline, piperizine, lutidine, pyrimidine, pyridazine, 4,4'-trimethylenedipyridine, 2-(methylamino)pyrizine, pyrazine, quinoline, quinoxaline, triazine, pyrrole, 3-pyrroline, imidazole, triazole, tetrazole, 1-methylpyrrolidine, and the like; aliphatic or aromatic amines, such as methylamine, dimethylamine, trimethylamine, ethyamine, diethyamine, triethylamine, propylamine, dipropylamine, tripropylamine, butylamine, dibutylamine, tributylamine, pentylamine, dipentylamine, tripentylamine, hexylamine, dihexylamine, trihexylamine, heptylamine, diheptylamine, octylamine, dioctylamine, trioctylamine, phenylamine, diphenylamine, triphenylamine, and the like; DBU(1,8-diazabicyclo[5,4,0]7-undecene), DBN(1,5-diazabicyclo[4,3,0]5-nonene), 1,5,9-triazacyclododecane, and 1,4,7-triazacyclononane.

The silica conversion accelerating catalyst may be present in an amount of 0.1% by weight (wt%) to 10 wt% in a total weight of the polysilazine, particularly, perhydropolysilazane.

By coating the surface of the bezel for display panels according to the invention with a polysilazane solution, a highly dense film may be formed on the surface of the bezel. In addition, the bezel according to the invention has outstanding properties in terms of corrosion resistance, abrasion resistance, antifouling, ease of cleaning, wettability, sealing effects, chemical resistance, oxidation resistance, physical barrier effects, heat resistance, fire resistance, low shrinkage, smoothing effects, durability, antistatic properties, scratch resistance, and the like.

Any coating method may be used without limitation to coat the surface of the bezel with the glass film. Advantageously, spray coating, dip coating, spin coating, and the like may be used.

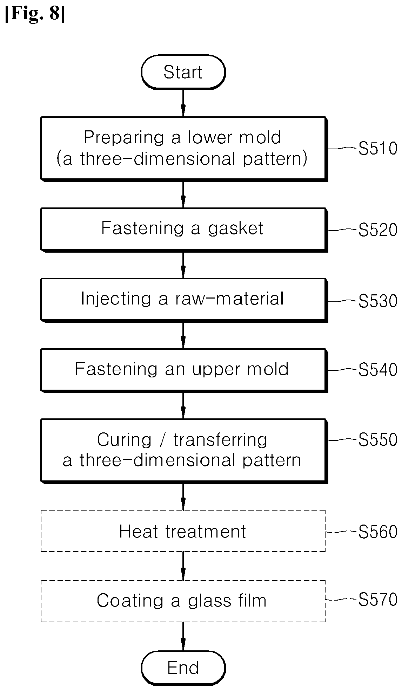

Fig. 8 is a schematic flowchart of a method for manufacturing a bezel for display panels according to another embodiment of the present invention.

Referring to Fig. 8, a method for manufacturing a bezel for display panels includes: preparing a lower mold (S510); fastening a gasket (S520); injecting araw material (S530); fastening an upper mold (S540); and curing/transferring a three-dimensional pattern (S550). In addition, the method further include heat treatment (S560), and may further include coating a glass film (S570).

In operation (S510) of preparing a lower mold, the lower mold formed on a molding surface thereof with a three-dimensional pattern for imparting a surface shape to the bezel is prepared. In operation (S520) of fastening a gasket, the gasket is fastened to a rim of the molding surface of the lower mold.

In operation (S530) of injecting a raw material, the raw material for the bezel is injected onto the molding surface of the lower mold. In operation (S540) of fastening an upper mold, the upper mold is fastened to the gasket on the lower mold.

In operation (S550) of curing/transferring a three-dimensional pattern, the injected raw material is thermally cured, while transferring the three-dimensional pattern from the molding surface of the lower mold to a cured product of the raw material. In operation (S560) of heat treatment, monomers and other components unreacted during curing are further cured.

In operation (S570) of coating a glass film, at least one surface of the bezel formed of a cured polymeric raw material is coated with the glass film, wherein the at least one surface has a transferred three-dimensional pattern.

As shown in Fig. 8, after the raw material is injected onto the molding surface of the lower mold, the upper mold may be fastened to the lower mold. In this case, the upper mold may not have a raw material injection port.

As shown in Fig. 1, the raw material may be injected after fastening the upper mold and the lower mold in order to prevent foreign matter from entering the molds and to adjust an injection amount of the raw material. On the other hand, as shown in Fig. 8, the upper mold may be fastened to the lower mold after injecting the raw material onto the molding surface of the lower mold in order to allow convenient injection of the raw material.

In the embodiments shown in Figs. 1 and 8, the methods for manufacturing a bezel for display panels through heat curing are illustrated.

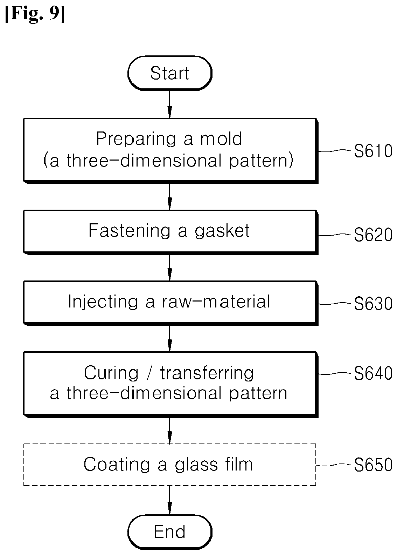

Fig. 9 is a schematic flowchart of a method for manufacturing a bezel for display panels according to a further embodiment of the present invention.

Referring to Fig. 9, the method for manufacturing a bezel for display panels includes: preparing a mold (S610); fastening a gasket (S620); injecting a raw material (S630); and curing/transferring a three-dimensional pattern (S640).

The method may further include coating a glass film (S640).

In operation (S610) of preparing a mold, a mold formed on a molding surface thereof with a three-dimensional pattern for imparting a surface shape to the bezel is prepared.

In operation (S620) of fastening a gasket, the gasket is fastened to a rim of the molding surface of the mold.

In operation (S630) of injecting a raw material, the raw material for the bezel is injected onto the molding surface of the mold. The raw material may be a resin composition curable by heat, light or electron beam.

In operation (S640) of curing/transferring a three-dimensional pattern, the injected raw material is cured while transferring the three-dimensional pattern from the molding surface of the mold to a cured product of the raw material. In this case, various curing processes may be applied depending on which raw materials employed.

For example, when using a thermosetting resin composition as the raw material, heat curing may be used. On the other hand, when using an ultraviolet curable resin composition as the raw material, ultraviolet curing may be carried out.

In operation (S650) of coating a glass film, at least one surface of the bezel formed of a cured polymeric raw material is coated with the glass film, in which the at least one surface has a transferred three-dimensional pattern.

A bezel for display panels manufactured by the method according to embodiments of the invention facilitates formation of a three-dimensional pattern on a surface thereof while reducing unnecessary material costs.

The bezel for display panels includes: a substrate formed of a cured product of a resin composition, the substrate having a three-dimensional pattern on at least one surface thereof; and a glass film coated on the at least one surface of the substrate.

The bezel may be formed to have a transparent color or a white color depending on which raw materials are employed.

Particularly, the three-dimensional pattern may be formed to have a thickness of 1 mm or more on a surface of the bezel. As described above, this can be achieved using metals, and the like having properties for easy formation of patterns as a material for a mold, and applying NC machining, and the like to a molding surface of the mold, and as a result, by forming a three-dimensional pattern having a thickness of 1mm or more on the mold.

## Claims

1. A method for manufacturing a bezel surrounding and supporting a rim of a display panel, comprising:
(a) preparing a mold (S110, S510, S610), the mold being formed on a molding surface thereof with a three-dimensional pattern for imparting a surface shape to a bezel and the molding surface of the mold is coated with a release agent;
(b) fastening a gasket (S210, S510, S620) to a rim of the molding surface of the mold;
(c) injecting a polymeric raw material (S140, S530, S630) for the bezel onto the molding surface of the mold; and
(d) curing the polymeric raw material (S150, S550, S640) while transferring the three-dimensional pattern from the molding surface of the mold to the polymeric raw material;
(e) further curing an unreacted portion of the polymeric raw material through a heat treatment (S160, S560),
(g) coating at least one surface of the bezel with a glass film (S170, S570, S650), the at least one surface of the bezel comprising a transferred three-dimensional pattern, and the bezel being formed of a cured polymeric raw material,
wherein the mold comprises a frame attached to an outer surface of the mold, and the frame is formed of a glass or metal honeycomb plate.

2. A method for manufacturing a bezel according to claim 1, wherein
(a) the mold to be prepared is a lower mold (210), the lower mold being formed on a molding surface (215) thereof with a three-dimensional pattern for imparting a surface shape to a bezel;
(b) fastening a gasket (220) to a rim of the molding surface of the mold;
(c) fastening an upper mold (410) to the gasket, the upper mold being formed with a raw material injection port and then injecting the polymeric raw material for the bezel onto the molding surface of the mold through the raw material injection port of the upper mold; and
(d) curing the polymeric raw material while transferring the three-dimensional pattern from the molding surface of the lower mold to the polymeric raw material.

3. A method for manufacturing a bezel according to claim 1, wherein
(a) the mold to be prepared is a lower mold being formed on a molding surface thereof with a three-dimensional pattern for imparting a surface shape to a bezel;
(b) fastening a gasket to a rim of the molding surface of the lower mold;
(c) injecting the polymeric raw material for the bezel onto the molding surface of the lower mold and then fastening an upper mold to the gasket on the lower mold; and
(d) curing the polymeric raw material while transferring the three-dimensional pattern from the molding surface of the lower mold to the polymeric raw material.

4. The method according to any of the previous claims, wherein the glass film of step (g) comprises a polysilazane.

5. The method according to claim 4, wherein the polysilazane comprises repeated units represented by Formula 1: 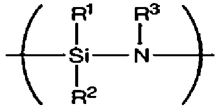 wherein R¹, R² and R³ are a hydrogen atom or a C₁-C₈ alkyl group, such as a methyl group, an ethyl group, a propyl group, and a butyl group.

6. The method according to claim 4 or 5, wherein the polysilazane is perhydropolysilazane.

7. The method according to claim 4, 5 or 6, wherein the polysilazane comprises a catalytic amount of a silica conversion accelerating catalyst, and the silica conversion accelerating catalyst comprises an amine catalyst.

8. The method according to claim 2 or 3, wherein the three-dimensional pattern on the molding surface of the lower mold is formed using at least one process of NC (numerical control) machining, chemical etching, and stamping.

9. The method according to claim 1 or 2 or 3, wherein the polymeric raw material injected in step (c) is a thermosetting resin composition and the resin composition has a viscosity of 300 cPs to 500 cPs.

10. The method according to claim 2 or 3, wherein the lower mold is formed of at least one material selected from the group consisting of metal, Teflon, and rubber materials.

11. The method according to claim 2 or 3, wherein the upper mold is formed of glass or metal and has a planar molding surface.

12. The method according to claim 2 or 3, wherein the upper mold is formed on a molding surface thereof with an opposite pattern to the three-dimensional pattern formed on the molding surface of the lower mold.

## Patentansprüche

1. Verfahren zur Herstellung einer einen Rand einer Anzeigetafel umgebenden und unterstützenden Blende, umfassend:
(a) Bereitstellen einer Form (S110, S510, S610), wobei die Form auf einer Formungsoberfläche davon mit einem dreidimensionalen Muster gebildet wird, um einer Blende eine Oberflächengestaltung zu verleihen, und die Formungsoberfläche der Form mit einem Entformungsmittel beschichtet wird;
(b) Befestigen einer Dichtung (S210, S510, S620) an einem Rand der Formungsoberfläche der Form;
(c) Einspritzen eines Polymerrohmaterials (S140, S530, S630) für die Blende auf die Formungsoberfläche der Form; und
(d) Aushärten des Polymerrohmaterials (S150, S550, S640), während das dreidimensionale Muster von der Formungsoberfläche der Form auf das Polymerrohmaterial übertragen wird;
(e) weiteres Aushärten eines unumgesetzten Anteils des Polymerrohmaterials durch Wärmebehandlung (S160, S560),
(g) Beschichten von mindestens einer Oberfläche der Blende mit einem Glasfilm (S170, S570, S650), wobei die mindestens eine Oberfläche der Blende ein übertragenes dreidimensionales Muster umfasst, und die Blende aus einem ausgehärteten Polymerrohmaterial gebildet ist,
wobei die Form einen an einer Außenfläche der Form befestigten Rahmen umfasst, und der Rahmen aus einer Glas- oder Metallwabenplatte gebildet ist.

2. Verfahren zur Herstellung einer Blende nach Anspruch 1, wobei
(a) die bereitzustellende Form eine untere Form (210) ist, wobei die untere Form auf einer Formungsoberfläche (215) davon mit einem dreidimensionalen Muster gebildet wird, um einer Blende eine Oberflächengestaltung zu verleihen;
(b) Befestigen einer Dichtung (220) an einem Rand der Formungsoberfläche der Form;
(c) Befestigen einer oberen Form (410) an der Dichtung, wobei die obere Form mit einer Einspritzöffnung für Rohmaterial gebildet ist, und dann Einspritzen des Polymerrohmaterials für die Blende auf die Formungsoberfläche der Form durch die Einspritzöffnung für Rohmaterial der oberen Form; und
(d) Aushärten des Polymerrohmaterials, während das dreidimensionale Muster von der Formungsoberfläche der unteren Form auf das Polymerrohmaterial übertragen wird.

3. Verfahren zur Herstellung einer Blende nach Anspruch 1, wobei
(a) die bereitzustellende Form eine untere Form ist, die auf einer Formungsoberfläche davon mit einem dreidimensionalen Muster gebildet wird, um einer Blende eine Oberflächengestaltung zu verleihen;
(b) Befestigen einer Dichtung an einem Rand der Formungsoberfläche der unteren Form;
(c) Einspritzen des Polymerrohmaterials für die Blende auf die Formungsoberfläche der unteren Form und dann Befestigen einer oberen Form an der Dichtung auf dem unteren Form; und
(d) Aushärten des Polymerrohmaterials, während das dreidimensionale Muster von der Formungsoberfläche der unteren Form auf das Polymerrohmaterial übertragen wird.

4. Verfahren nach einem der vorgehenden Ansprüche, wobei der Glasfilm von Schritt (g) ein Polysilazan umfasst.

5. Verfahren nach Anspruch 4, wobei das Polysilazan wiederholte Einheiten umfasst, dargestellt durch Formel 1: 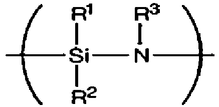 wobei R¹, R² und R³ ein Wasserstoffatom oder eine C₁-C₈-Alkylgruppe sind, wie beispielsweise eine Methylgruppe, eine Ethylgruppe, eine Propylgruppe und eine Butylgruppe ist.

6. Verfahren nach Anspruch 4 oder 5, wobei das Polysilazan Perhydropolysilazan ist.

7. Verfahren nach Anspruch 4, 5 oder 6, wobei das Polysilazan eine katalytische Menge an einem Silicaumsetzungsbeschleunigungskatalysator umfasst, und der Silicaumsetzungsbeschleunigungskatalysator einen Aminkatalysator umfasst.

8. Verfahren nach Anspruch 2 oder 3, wobei das dreidimensionale Muster auf der Formungsoberfläche der unteren Form unter Anwendung von mindestens einem Prozess von NC (numerischer Steuerung) maschineller Bearbeitung, chemischem Ätzen und Prägen gebildet wird.

9. Verfahren nach Anspruch 1, 2 oder 3, wobei das in Schritt (c) eingespritzte Polymerrohmaterial eine thermohärtende Harzzusammensetzung ist, und die Harzzusammensetzung eine Viskosität von 300 cPs bis 500 cPs aufweist.

10. Verfahren nach Anspruch 2 oder 3, wobei die untere Form aus mindestens einem Material aus der Gruppe bestehend aus Metall-, Teflon- und Gummimaterialien gebildet wird.

11. Verfahren nach Anspruch 2 oder 3, wobei die obere Form aus Glas oder Metall gebildet wird und eine ebene Formungsoberfläche aufweist.

12. Verfahren nach Anspruch 2 oder 3, wobei die obere Form auf einer Formungsoberfläche davon mit einem Muster gebildet wird, das zum dreidimensionalen, auf der Formungsoberfläche der unteren Form gebildeten Muster entgegengesetzt ist.

## Revendications

1. Procédé de fabrication d'une lunette entourant et supportant un rebord d'un panneau d'affichage, comprenant:
(a) la préparation d'un moule (S110, S510, S610), le moule étant formé sur une surface de moulage de celui-ci avec un motif tridimensionnel pour conférer une forme de surface à une lunette, et la surface du moulage étant revêtue d'un agent de démoulage;
(b) la fixation d'un joint d'étanchéité (S210, S510, S620) à un rebord de la surface de moulage du moule;
(c) l'injection d'une matière première polymère (S140, S530, S630) pour la lunette sur la surface de moulage du moule; et
(d) le durcissement de la matière première polymère (S150, S550, S640) tout en transférant le motif tridimensionnel de la surface de moulage du moule à la matière première polymère;
(e) le durcissement supplémentaire d'une partie non réagie de la matière première par traitement thermique (S160, S560),
(g) le revêtement d'au moins une surface de la lunette avec un film de verre (S170, S570, S650), l'au moins une surface de la lunette comprenant un motif tridimensionnel transféré, et la lunette étant formée d'une matière première polymère durcie,
dans lequel le moule comprend un cadre attaché à une surface extérieure du moule, et le cadre est formé d'une plaque en nid d'abeille en verre ou en métal.

2. Procédé de fabrication d'une lunette selon la revendication 1, dans lequel
(a) le moule à préparer est un moule inférieur (210), le moule inférieur étant formé sur une surface de moulage (215) de celui-ci avec un motif tridimensionnel pour conférer une forme de surface à une lunette;
(b) la fixation d'un joint d'étanchéité (220) à un rebord de la surface de moulage du moule;
(c) la fixation d'un moule supérieur (410) au joint d'étanchéité, le moule supérieur étant formé avec un orifice d'injection de matière première et ensuite l'injection de la matière première polymère pour la lunette sur la surface de moulage du moule à travers l'orifice d'injection de matière première du moule supérieur; et
(d) le durcissement de la matière première polymère tout en transférant le motif tridimensionnel de la surface de moulage du moule inférieur à la matière première polymère.

3. Procédé de fabrication d'une lunette selon la revendication 1, dans lequel
(a) le moule à préparer est un moule inférieur étant formé sur une surface de moulage de celui-ci avec un motif tridimensionnel pour conférer une forme de surface à une lunette;
(b) la fixation d'un joint d'étanchéité à un rebord de la surface de moulage du moule inférieur;
(c) l'injection de la matière première polymère pour la lunette sur la surface de moulage du moule inférieure et ensuite la fixation d'un moule supérieur au joint d'étanchéité sur le moule inférieur; et
(d) le durcissement de la matière première polymère tout en transférant le motif tridimensionnel à partir de la surface de moulage du moule inférieur vers la matière première polymère.

4. Procédé selon l'une quelconque des revendications précédentes, dans lequel le film de verre de l'étape (g) comprend un polysilazane.

5. Procédé selon la revendication 4, dans lequel le polysilazane comprend des motifs répétés formule 1: 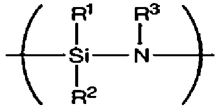 représentés par la où R¹, R² et R³ sont un atome d'hydrogène ou un groupe alkyle en C₁-C₈, tel qu'un groupe méthyle, un groupe éthyle, un groupe propyle et un groupe butyle.

6. Procédé selon la revendication 4 ou 5, dans lequel le polysilazane est le perhydropolysilazane.

7. Procédé selon la revendication 4, 5 ou 6, dans lequel le polysilazane comprend une quantité catalytique d'un catalyseur d'accélération de la conversion de la silice et le catalyseur d'accélération de la conversion de la silice comprend un catalyseur aminé.

8. Procédé selon la revendication 2 ou 3, dans lequel le motif tridimensionnel sur la surface de moulage du moule inférieur est formé en utilisant au moins un procédé d'usinage à commande numérique (CN), de gravure chimique et d'estampage.

9. Procédé selon la revendication 1 ou 2 ou 3, dans lequel la matière première polymère injectée à l'étape (c) est une composition de résine thermodurcissable, et la composition de résine a une viscosité de 300 cP à 500 cPs.

10. Procédé selon la revendication 2 ou 3, dans lequel le moule inférieur est formé d'au moins un matériau sélectionné du groupe consistant en matériaux en métal, en téflon et en caoutchouc.

11. Procédé selon la revendication 2 ou 3, dans lequel le moule supérieur est formé de verre ou de métal et a une surface de moulage plane.

12. Procédé selon la revendication 2 ou 3, dans lequel le moule supérieur est formé sur une surface de moulage de celui-ci avec un motif opposé au motif tridimensionnel formé sur la surface de moulage du moule inférieur.
